(19) **Europäisches Patentamt**

**European Patent Office**

**Office européen des brevets**

(11) **EP 2 366 117 B1**

(12) **FASCICULE DE BREVET EUROPEEN**

(45) Date de publication et mention
de la délivrance du brevet:
**26.12.2012 Bulletin 2012/52**

(51) Int Cl.:
***G01S 7/02*** *(2006.01)* ***G01R 23/12*** *(2006.01)*
***G01R 23/175*** *(2006.01)*

(21) Numéro de dépôt: **09752178.5**

(22) Date de dépôt: **13.11.2009**

(86) Numéro de dépôt international:
**PCT/EP2009/065102**

(87) Numéro de publication internationale:
**WO 2010/069683 (24.06.2010 Gazette 2010/25)**

(54) **RECEPTEUR NUMERIQUE LARGE BANDE COMPRENANT UN MECANISME DE DETECTION DE SIGNAUX**

BREITBANDIGER DIGITALEMPFÄNGER MIT EINEM SIGNALDETEKTIONSMECHANISMUS

WIDEBAND DIGITAL RECEIVER COMPRISING A SIGNAL DETECTION MECHANISM

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **16.12.2008 FR 0807070**

(43) Date de publication de la demande:
**21.09.2011 Bulletin 2011/38**

(73) Titulaire: **THALES**
**92200 Neuilly-sur-Seine (FR)**

(72) Inventeur: **BRIAND, Thierry**
**F-78290 Croissy sur Seine (FR)**

(74) Mandataire: **Brunelli, Gérald et al**
**Marks & Clerk France**
**Immeuble Visium**
**22, avenue Aristide Briand**
**94117 Arcueil Cedex (FR)**

(56) Documents cités:
**US-A- 4 336 541 US-A- 4 547 727**
**US-B1- 7 266 465**

• **ADAM KONRAD RUTKOWSKI ET AL: "Identification of frequencies and amplitudes of microwave simultaneous signals by means of IFM methods" MICROWAVES, RADAR AND WIRELESS COMMUNICATIONS, 2008. MIKON 2008. 17TH INTERNATIONAL CONFERENCE ON, IEEE, PISCATAWAY, NJ, USA, 19 mai 2008 (2008-05-19), pages 1-4, XP031324644 ISBN: 978-83-906662-8-0**

**Description**

L'invention concerne un récepteur numérique large bande comprenant un mécanisme de détection de signaux.

Les récepteurs destinés à la détection de signaux radioélectriques, par exemple de type radar, doivent être capables de surveiller de larges bandes de fréquence notamment dans le domaine des micro-ondes. Ils doivent pouvoir détecter, par exemple, des impulsions de signaux radar. Ces impulsions peuvent présenter des modulations de type « chirp » ou de type code de phase, ces modulations étant utilisées par le radar pour comprimer l'impulsion à la réception. Les impulsions peuvent également être non modulées, si ce n'est par la modulation en tout ou rien définissant l'impulsion. Ces récepteurs ont, entre autres, pour rôle d'estimer la ou les fréquences du ou des signaux reçus ainsi que leur amplitude.

Bien que des traitements numériques interviennent habituellement dans l'architecture de ces récepteurs, les solutions actuelles visant à estimer les fréquences des signaux reçus, désignés dans la suite de la description par le sigle IFM ("Instantaneous Frequency Measurement" en langue anglaise), s'appuient majoritairement sur des techniques analogiques.

A titre d'exemple, une solution existante permettant une mesure instantanée de la fréquence du signal reçu est basée sur la création d'un régime d'ondes stationnaires dans une ligne de propagation attaquée à l'une de ses extrémités par le signal et à l'autre par le signal retardé. La périodicité des noeuds et des ventres donne une mesure grossière de la fréquence du signal reçu. La mesure de la position des noeuds et des ventres répartis le long de cette ligne donne une mesure fine de la fréquence du signal reçu. Ce type d'IFM est appelé fréquencemètre à échantillonnage spatial.

Une autre solution de l'état de l'art, qui est très répandue, est à base d'auto-corrélateurs ou de phasemètres. Le principe est dans ce cas de mesurer directement la différence de phase φ induite par une ligne à retard et d'en déduire la fréquence. Plusieurs étages, mis en parallèle, sont généralement nécessaires pour assurer la bande de fréquences et la précision souhaitées.

Les récepteurs mettant en oeuvre ces solutions utilisent des fonctions analogiques et sont donc soumis à des dérives telles que des variations de retards en fonction de la température, des imperfections de mesure de niveau ou de déphasage. Ceci induit une architecture volumineuse et un coût important.

Plus récemment, une demande de brevet français concernant un *récepteur numérique large bande de mesure de fréquence* déposée sous le N° 06/01205 décrit, à la différence des deux exemples précédents, une manière de numériser le signal dès l'entrée, et d'effectuer tous les traitements en numérique. La numérisation est effectuée à une fréquence d'échantillonnage très inférieure au critère de Shannon. Cela se traduit par une mesure de fréquence ambiguë $F_{mesure}$, également appelée fréquence fine dans la suite de la description, ladite fréquence pouvant être décrite par l'expression suivante :

$$F_{mesure} = \pm\left(F_{réelle} - j \times F_e\right) + \delta F \qquad (1)$$

dans laquelle $F_{réelle}$ est la fréquence réelle du signal reçu, j un entier positif, $F_e$ la fréquence d'échantillonnage du système et $\delta F$ est l'erreur de mesure due principalement au rapport signal à bruit.

Pour lever cette ambiguïté, N voies de mesure sont utilisées en parallèle, avec des fréquences d'échantillonnage décalées. Les N mesures de fréquences ambiguës sont associées pour lever ladite ambiguïté et obtenir une mesure de la fréquence réelle du signal incident. Cette mesure est appelée fréquence finale dans la suite de la description.

Lorsqu'un dispositif de mesure de fréquence instantanée est utilisé, celui-ci est habituellement couplé avec un second dispositif dont le but est de mesurer l'amplitude. Ceci permet notamment de détecter la présence ou l'absence de signaux ainsi que leurs caractéristiques associées. En effet, ces IFM fonctionnent dans une grande dynamique. Celle-ci est obtenue grâce à l'utilisation d'un amplificateur limiteur en tête du dispositif et supprime toute information de niveau. Ce type d'IFM ne possède donc pas de capacité propre de détection de l'enveloppe des impulsions de signal reçues. C'est pour cela qu'il est habituellement associé à un dispositif de mesure de niveau, par exemple de type DLVA, sigle signifiant « Detector Logarithm Video Amplifier ». Ce dernier fournit une information complémentaire sur l'amplitude du ou des signaux reçus et permet notamment de valider ou d'invalider la mesure de fréquence produite par l'IFM ainsi que d'estimer l'enveloppe des signaux reçus. L'ajout d'un tel dispositif induit de fait une taille et un coût plus importants.

Le document US 7266465 B1 divulgue un récepteur comportant un IFM numérique et un indicateur de cohérence des mesures de fréquence.

Un but de l'invention est notamment de minimiser les inconvénients précités. Cet objectif est réalisé au moyen du récepteur défini dans la revendication 1.

A cet effet, l'invention a pour objet un récepteur numérique hyperfréquence à large bande comprenant au moins une antenne, un amplificateur et un dispositif IFM numérique de mesure de la fréquence du ou des signaux reçus. Un indicateur de cohérence des mesures de fréquence est calculé par le récepteur en analysant les valeurs que prennent lesdites mesures obtenues sur deux transformées consécutives et la présence d'impulsions de signal à l'entrée du récepteur est détectée lorsque ledit indicateur signale la cohérence d'au moins une mesure de fréquence.

L'enveloppe de la ou des impulsions reçues est estimée en utilisant au moins l'indicateur de cohérence et les mesures de fréquence calculés par l'IFM.

Les signaux reçus par le récepteur sont, par exemple, des impulsions radar.

Selon un aspect de l'invention, l'indicateur de cohérence est un indicateur binaire.

Selon un mode de réalisation, le récepteur associe une impulsion de signal détectée à une piste de détection, une piste de détection étant définie par une valeur de fréquence $F_{courante}$ et un écart de fréquence $\Delta_{detec}$. Une mesure de fréquence est associée à ladite piste lorsque celle-ci appartient à la plage de fréquence $F_{courante}$ +/- $\Delta_{detec}$.

Des impulsions de signal distinctes se chevauchant temporellement sont détectées, par exemple, en maintenant simultanément ouvertes plusieurs pistes de détection.

Selon un autre aspect de l'invention, la date d'arrivée TOA, sigle venant de l'expression anglaise « Time of Arrival », d'une impulsion détecté correspond à la date d'ouverture de la piste de détection associée à ladite impulsion.

La largeur d'une impulsion détectée LI peut être déterminée par la différence entre la date de la dernière mesure affectée à cette piste et la date d'ouverture de la piste de détection associée à ladite impulsion.

La ou les pistes de détection ouvertes à un instant donné sont, par exemple, fermées lorsqu'un nombre prédéfini de mesures de fréquence sont successivement jugées incohérentes.

Le récepteur selon l'invention a notamment pour avantage de pouvoir détecter la présence et l'enveloppe d'un ou de plusieurs signaux en exploitant les résultats des opérations réalisées par l'IFM numérique. Cela permet d'avoir une architecture de récepteur ne nécessitant pas de dispositif de mesure de niveau et réduit donc la complexité dudit récepteur, et par conséquent son coût.

D'autres caractéristiques et avantages de l'invention apparaîtront à l'aide de la description qui suit donnée à titre illustratif et non limitatif, faite en regard des dessins annexés parmi lesquels :

- la figure 1 donne un exemple d'impulsion de signal et ses caractéristiques ;
- la figure 2 présente un exemple de récepteur numérique large bande comprenant un mécanisme de mesure de fréquence et un mécanisme de détection d'enveloppe ;
- la figure 3 présente un exemple de diagramme détaillant les différentes étapes menant à la détection et à l'acquisition de l'enveloppe des impulsions reçues ;
- la figure 4 illustre graphiquement le cas où deux impulsions de signal sont superposées.

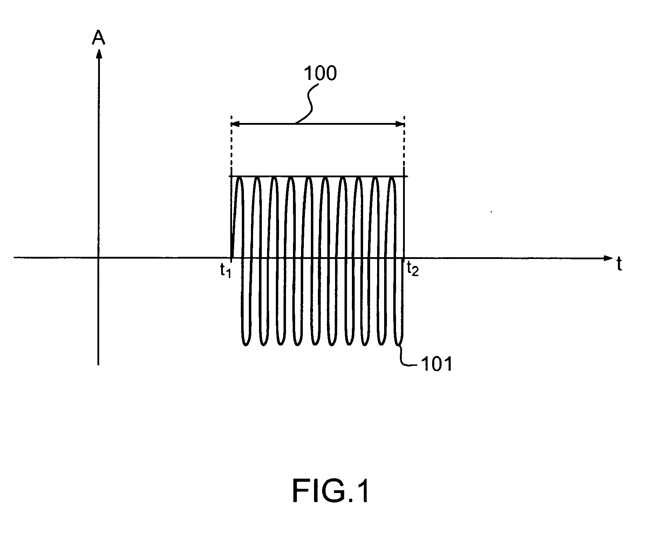

La figure 1 donne un exemple d'une impulsion 100 de signal et ses caractéristiques. Le récepteur large bande selon l'invention a notamment pour but de détecter des impulsions de signaux hyperfréquence. Cette détection peut être réalisée, par exemple, en deux temps. Dans un premier temps, le récepteur comprenant un IFM numérique s'assure de la présence d'une ou de plusieurs impulsions en réception en vérifiant la cohérence des mesures de fréquence. La notion de cohérence des mesures est détaillée plus loin dans la description. Dans un second temps, les caractéristiques de l'impulsion sont acquises par analyse des mesures. Un exemple d'impulsion de signal dans le domaine temporel est représenté sur la figure 1. Dans cette exemple, l'impulsion correspond à une sinusoïde pure, c'est-à-dire un signal non modulé, reçue au temps $t_1$ et se terminant au temps $t_2$.

Les paramètres associés à l'impulsion, que l'invention cherche à estimer, sont notamment la date d'arrivée de l'impulsion, habituellement désignée par le sigle TOA venant de l'expression anglaise « Time of Arrival », la largeur d'impulsion désignée par le sigle LI et la fréquence centrale du signal composant ladite impulsion.

La date d'arrivée de l'impulsion TOA correspond au temps $t_1$. La largeur d'impulsion LI 100 est définie par la différence entre la date de fin de l'impulsion $t_2$ et la date d'arrivée de l'impulsion $t_1$, soit $LI = t_2 - t_1$.

L'impulsion peut également être caractérisée par la fréquence centrale du signal 101 contenu dans ladite impulsion, et lorsque celle-ci est modulée, par des paramètres de modulation de fréquence et de phase.

L'ensemble de ces paramètres caractéristiques d'une impulsion composent ce qui est appelé enveloppe de l'impulsion dans la présente description.

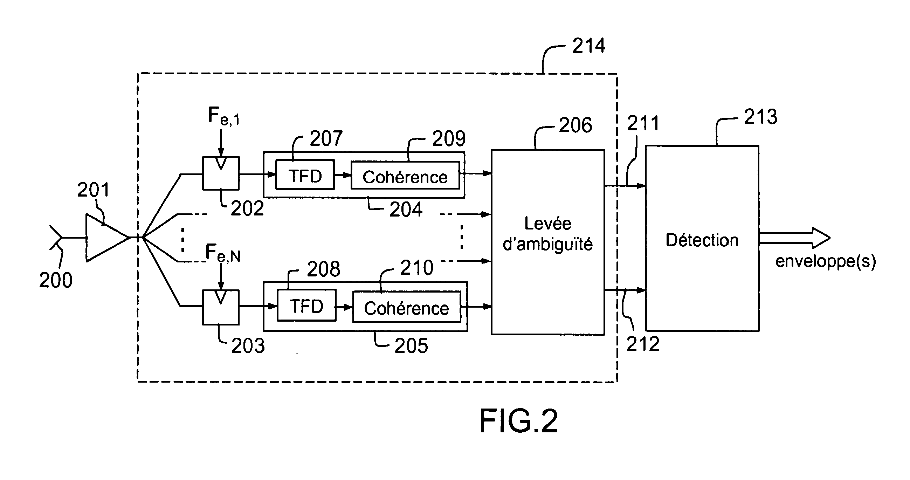

Le figure 2 présente un exemple de récepteur numérique large bande selon l'invention comprenant circuit radiofréquence de réception 200, 201, un dispositif de mesure de fréquence IFM 214 et un dispositif de détection d'enveloppe 213. Le récepteur comprend au moins une antenne 200 de réception. Le ou les signaux reçus par ladite antenne sont amplifiés 201 puis distribués sur N voies de traitement numériques. Sur chaque voie le signal peut être, par exemple, numérisé sur 1 bit par une bascule 202, 203 dont la bande passante couvre le domaine de la bande à traiter. Les N fréquences d'échantillonnage notées de $F_{e,1}$ à $F_{e,N}$ sont choisies en dessous du critère d'échantillonnage de Shannon et légèrement décalées entre elles. En d'autres termes, si $F_{max}$ est la fréquence maximum du ou des signaux à recevoir, les N fréquences d'échantillonnage sont choisies inférieures à $2 \times F_{max}$.

Chaque voie de traitement comprend un fréquencemètre numérique 204, 205 dont la sortie est une mesure de fréquence ambiguë du signal reçu telle qu'exprimée précédemment par l'équation (1). Ces fréquencemètres numériques réalisent des transformées de Fourier discrètes 207, 208, habituellement désignées par le sigle TFD, et sont effectuées en continu avec un recouvrement temporel, par exemple, de 50%. Une détection de maximum est effectuée sur chaque résultat $TFD_i$ de transformée, i désignant l'indice temporel desdites transformées. Une mesure de fréquence dite grossière notée $FG_{k,i}$ est alors disponible. La résolution en fréquence $R(FG_{k,i})$ de cette mesure peut être exprimée en utilisant l'expression suivante :

$$R\left(FG_{k,i}\right)=\frac{F_{e,k}}{N\_pt\_TFD\_k} \tag{2}$$

dans laquelle N_pt_TFD_k est le nombre de points de la transformée de Fourier discrète pour la voie de traitement numéro k et $F_{e,k}$ la fréquence d'échantillonnage utilisée pour cette même voie.

Les mesures sont émises périodiquement toutes les $\tau$ secondes, $\tau$ pouvant s'exprimer par :

$$\tau=\frac{N\_pt\_acq\_k}{2\times F_{e,k}} \tag{3}$$

dans laquelle N_pt_acq_k représente le nombre de points d'acquisition du signal utilisé sur la voie k.

La précision de la mesure de fréquence obtenue à ce stade est insuffisante par rapport à la précision requise.

Le circuit de traitement suivant 209, 210 a pour but de tester la cohérence de la fréquence grossière $FG_i$ obtenue sur 2 transformées consécutives, et le cas échéant de calculer la fréquence fine. Un critère de cohérence est, par exemple, de vérifier si l'écart entre $FG_{k,i}$ et $FG_{k,i-1}$ est supérieur à une raie de la TFD. Si c'est le cas, la voie k est considérée incohérente et la mesure d'indice i de la voie k est invalidée. Dans le cas contraire, la voie est considérée cohérente et la mesure est validée et la valeur de la mesure est le résultat du calcul de fréquence fine.

Le calcul de la fréquence fine repose sur la différence de phase entre deux TFD consécutives. Ces deux TFD sont effectuées sur des supports d'intégration décalés d'un temps $\tau$. Dans le cas d'une sinusoïde pure, c'est-à-dire d'un signal non modulé, elles présentent une différence de phase pouvant s'exprimer à l'aide de l'expression suivante :

$$\Delta\varphi=2\times\pi\times F_{mesure}\times\tau \tag{4}$$

Le déphasage est mesuré modulo $2\pi$. Cette ambiguïté est levée par la mesure de fréquence grossière.

Les N voies fonctionnent en parallèle et sont synchronisées, c'est-à-dire que les séquences d'acquisition ont la même durée, soit $2\times\tau$ avec un recouvrement de 50%, et sont simultanées sur les N voies. Pour obtenir cette synchronisation, la valeur de $\tau$ est la même sur les N voies. Les décalages de fréquences d'échantillonnage sont compensés par des valeurs du nombre de point d'acquisition choisies légèrement différentes sur chaque voie, soit

$$\frac{N\_pt\_acq\_k}{2\times F_{e,k}}=\tau=Cte \text{ pour tout k.}$$

Les calculs TFD peuvent être faits soit sur le même nombre de points que N_pt_acq_k, ce qui nécessite des algorithmes particuliers, soit sur un nombre de points supérieur pour atteindre la valeur de $2^n$ supérieure par remplissage avec des zéros. Ainsi il est possible d'utiliser les algorithmes classiques de transformée de Fourier rapide, connue sous le sigle FFT, ledit sigle faisant référence à l'expression anglo-saxonne « Fast Fourier Transform ».

Etant donnée que les N voies de traitement fournissent des mesures de fréquence reçues à une ambiguïté près, il est nécessaire d'ajouter un mécanisme permettant d'obtenir une mesure fiable. Pour cela, un dispositif de levée d'ambiguïté 206 peut être utilisé.

Sur une voie, si le test de cohérence est satisfait (stabilité de la fréquence grossière), une mesure de fréquence fine est disponible. Suivant le nombre de voies cohérentes, 0 à N mesures de fréquence fine sont disponibles à l'entrée du dispositif de levée d'ambiguïté 206. Pour une valeur de $F_{max}$ très grande devant $F_e$ et un plan de fréquence adapté (choix des $F_{e,k}$), trois mesures fines correctes permettent de lever l'ambiguïté. Le but de la levée d'ambiguïté est de ne fournir que de bonnes mesures de la fréquence réelle. Il est possible qu'une mesure de fréquence fine soit erronée, par exemples, lorsque le rapport signal à bruit est trop faible ou en présence de signaux perturbateurs. Il est possible de choisir N>3, par exemple N=4, et des critères de rejet peuvent être mis en place afin d'éliminer les mesures pouvant être fausses. L'idée est alors de mettre en place une redondance permettant de détecter et de corriger certains cas d'erreur, dans ces cas la mesure finale est déclarée cohérente, ou bien de détecter certains cas d'erreur sans pouvoir corriger, dans ces cas la mesure finale est déclarée incohérente. Dans le cadre de cette redondance, il est choisi de ne pas privilégier une voie plutôt qu'une autre. A titre d'exemple, si N=4, il peut être décidé de déclarer la mesure finale incohérente si moins de trois voies sont cohérentes. Lorsque au moins trois voies sont cohérentes, il faut alors lever les ambiguïtés sur les mesures de fréquence fines fournies par ces voies cohérentes.

Pour une mesure ambiguë sur une voie, il y a plusieurs fréquences d'entrée possibles $F^P_{k,i}$. C'est ce qu'indique l'expression suivante :

$$F^p_{k,i} = \pm FF_{k,i} + j \times F_{e,k} \qquad (5)$$

dans laquelle j est un entier positif et $FF_{k,i}$ est la fréquence mesurée au niveau de la voie k et est compris entre 0 et $F_{e,k}/2$.

Le nombre de possibilités est fonction du taux de sous-échantillonnage, et donc du choix des fréquences d'échantillonnage $F_{e,k}$ pour chaque branche. Le principe de la levée d'ambiguïté est, par exemple, de rechercher parmi ces fréquences possibles $FP_{k,i}$, les candidats présentant des écarts entre voies inférieurs à un seuil donné. Par exemple, s'il y a 3 voies cohérentes, un triplet est recherché parmi les fréquences possibles. Une valeur $F^P_{k,i}$ étant disponible par voie, le triplet doit présenter des écarts entre voies inférieurs à un seuil. Lorsqu'un tel triplet est trouvé, la mesure de la fréquence fine est déclarée cohérente et la valeur fournie en sortie 211 est la moyenne des trois candidats retenus. Si aucun triplet ne satisfait à ce critère, la mesure de la fréquence finale est déclarée incohérente. Un indicateur de cohérence 212 de la mesure peut être présenté en sortie de dispositif de levée d'ambiguïté en parallèle de la valeur de fréquence fine mesurée.

Lorsque les N voies sont cohérentes, il est possible que malgré tout une voie puisse être fausse. Pour améliorer la fiabilité de la mesure de fréquence fine, il est possible d'ajouter un mécanisme de sécurité basé sur la vérification d'un critère de fiabilité. En utilisant un exemple où N=4 et où les quatre voies sont jugées cohérentes, une recherche de quatre triplets peut être alors effectuée parmi les fréquences possibles $F^P_{k,i}$ présentant des écarts entre voies inférieurs à un seuil de fiabilité.

Si les 4 triplets respectent le critère de fiabilité, ce qui revient en fait à trouver une groupe de 4 fréquences possibles présentant des écarts entre voies inférieurs au seuil de fiabilité, la mesure finale est déclarée cohérente et la mesure fournie est la moyenne des quatre candidats retenus.

Si un seul triplet respecte ce critère, la mesure finale est déclarée cohérente et la mesure fournie est la moyenne des 3 candidats de ce triplet. Cela revient à considérer que la voie qui n'a pas contribué à ce triplet est fausse. Dans les autres cas la mesure finale est déclarée incohérente.

Des cas particuliers peuvent être distingués pour certaines fréquences dites fréquences particulières. Par exemple, si $F_{réelle}$ est proche de $j \times (F_{e,k}/2)$ sur une voie, alors la phase de la TFD n'est plus représentative du signal. La fréquence fine issue de cette phase n'améliore pas la précision sur cette voie. La précision est réduite à la résolution de la TFD. Pour limiter l'erreur sur la fréquence finale, lorsqu'une voie est proche de $jx(F_{e,k}/2)$, la mesure sur cette voie participe à la levée d'ambiguïté, mais ne participe pas au calcul de moyenne pour la mesure finale.

Pour les autres fréquences particulières, notamment lorsque $F_{réelle}$ est proche de $j \times F_{e,k}/2 + F_{e,k}/4$, $j \times F_{e,k}/2 + F_{e,k}/6$ ou $j \times F_{e,k}/2 + F_{e,k} \times (2/6)$, la phase de la TFD, et donc le calcul de fréquence fine, est perturbée, mais dans une moindre mesure. Il n'est alors pas indispensable de réaliser un traitement particulier pour ces fréquences car la moyenne avec les autres voies donne une erreur suffisamment faible sur la mesure finale.

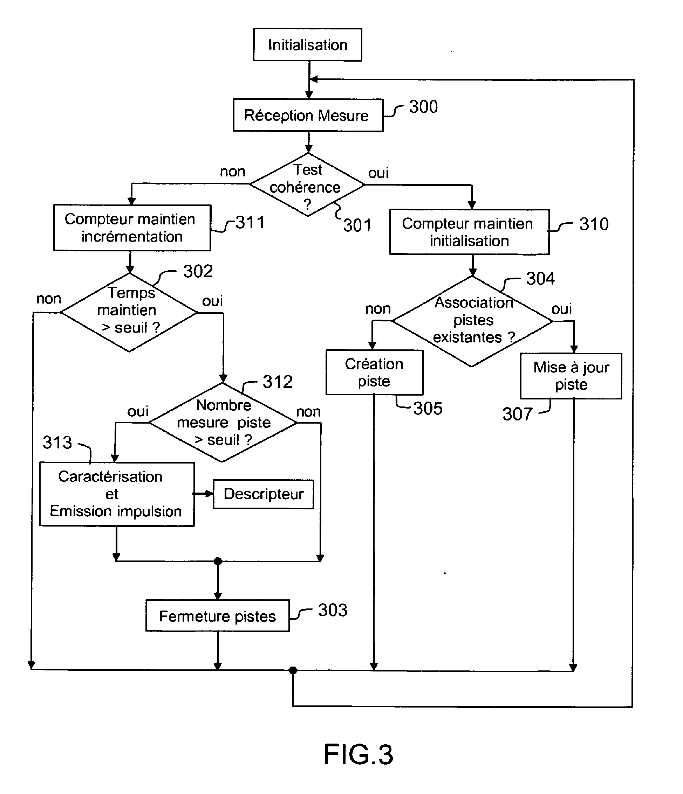

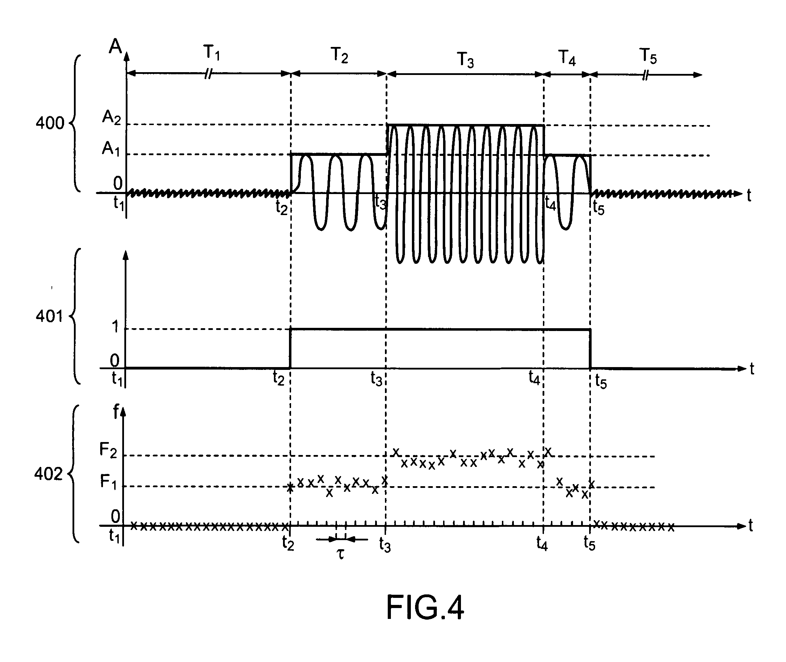

Afin d'analyser les propriétés des impulsions de signal, un dispositif de détection 213 exploitant les valeurs de mesures de fréquence 211 en parallèle des informations de cohérence 212 peut être mis en oeuvre. Le fonctionnement de ce dernier est décrit à l'aide des exemples des figures 3 et 4.

Les fonctions réalisées par les N voies 204, 205 d'estimations de fréquence, par les dispositifs de levée d'ambiguïté 206 et par le dispositif de détection 213 peuvent être implantées, par exemple, dans au moins un circuit programmable de type FPGA.

La figure 3 présente un exemple de diagramme détaillant les différentes étapes de calcul menant à la détection d'impulsions. La détection de présence est basée notamment sur l'indicateur de cohérence et la valeur des mesures de fréquence disponibles en sortie de l'IFM numérique. L'indicateur de cohérence, représentée par exemple sous forme booléenne avec '1' signifiant que la mesure est cohérente et '0' que la mesure est incohérente, est disponible en sortie de l'IFM numérique présenté figure 2. Il peut être associé à un mécanisme de pistage sur la fréquence dont le but est de détecter l'enveloppe des impulsions potentiellement reçues. Dans le cadre de cette description, le terme pistage signifie recherche de piste, une piste étant ici, par exemple, une impulsion radar. Ce mécanisme de pistage a notamment pour but de détecter l'enveloppe de la ou des impulsions présentant un rapport signal à bruit suffisant. Il vise également à séparer les impulsions se chevauchant temporellement.

Le mécanisme de pistage selon l'invention s'appuie notamment sur plusieurs observations :

- en absence de signal, c'est-à-dire avec uniquement du bruit thermique, la mesure de fréquence est quasi-systématiquement incohérente ;
- en présence d'un signal présentant un rapport signal à bruit suffisant, la mesure de fréquence est quasi-systématiquement cohérente ;
- en présence de plusieurs signaux simultanés, avec un écart de niveau suffisant et un rapport signal à bruit suffisant pour le plus fort d'entre eux, la mesure est quasi systématiquement cohérente et correspond au signal le plus fort.

Un exemple d'algorithme de pistage est explicité ci-après. Les mesures sont émises au rythme de $\tau$. Pour chaque mesure reçue 300, sa cohérence est vérifiée 301 afin de ne tenir compte que des mesures fiables. A l'apparition d'une mesure cohérente, un compteur de maintien est mis à zéro 310 et il est vérifié 304 si la mesure incidente peut être associée à une piste ouverte. Cette association est faite, par exemple, sur un critère d'écart de fréquence par rapport à une valeur courante de la piste. Si il y a association, la piste concernée est mise à jour 307. Si il n'y a pas d'association possible avec une des pistes ouvertes ou bien si il n'y a pas de piste ouverte, une nouvelle piste est créée 305.

A l'apparition d'une mesure incohérente, le compteur de maintien est incrémenté 311 et il est vérifié 302 si une valeur de temps de maintien est atteinte. Si c'est le cas, pour chaque piste ouverte il est vérifié 312 qu'un nombre minimum de mesures est disponible. Dans ce cas la piste est considérée comme une impulsion, ladite impulsion est alors caractérisée et un descripteur d'impulsion est émis avec ses caractéristiques 313. Lorsque le temps de maintien est atteint, qu'il y ait eu ou non émission de descripteur d'impulsion, toutes les pistes sont fermée 303.

Ainsi, il est également possible de rejeter des fausses alarmes isolées, même si ce cas n'est pas représenté sur la figure.

En outre, cette méthode permet une certaine tolérance des trous de détection. Un trou de détection correspond à une situation dans laquelle des mesures jugées incohérentes apparaissent malgré la présence d'un ou de plusieurs signaux à l'entrée du récepteur. C'est par exemple le cas en présence d'un signal à faible rapport signal à bruit ou en présence de deux signaux de même niveau de puissance.

A titre d'exemple, une piste interrompue par l'ouverture d'une nouvelle piste est maintenue ouverte. Le cas d'impulsions longues de faible niveau interrompues par une impulsion courte de plus fort niveau est ainsi traité. Ce cas est illustré à l'aide de la figure 4.

La figure 4 illustre graphiquement un exemple où deux impulsions de signal sont superposées. La première courbe 400 représente l'évolution temporelle de l'amplitude A d'une portion de signal telle que perçue par le récepteur. Dans cet exemple, deux impulsions sont présentes. La portion de signal peut être analysée en identifiant plusieurs tranches temporelles notées $T_1$ à $T_5$. Durant la première tranche $T_1$, aucun signal utile n'est présent. Le signal perçu par le récepteur correspond notamment au bruit thermique du récepteur. Une première impulsion de signal est reçue pendant les trois tranches temporelles suivantes $T_2$, $T_3$ et $T_4$. Dans l'exemple, cette impulsion correspond à une sinusoïde de fréquence $F_1$ et d'amplitude $A_1$. Une seconde impulsion sinusoïdale de fréquence $F_2$ et d'amplitude $A_2$, avec $A_2 > A_1$, est également présente pendant la troisième tranche temporelle $T_3$. Cette seconde impulsion est donc reçue en même temps qu'une partie de la première impulsion et est prépondérante par rapport à celle-ci de par son amplitude. La dernière tranche $T_5$ ne comporte pas de signal utile et possède les mêmes propriétés que la première tranche $T_1$.

La seconde courbe 401 représente l'évolution de l'indicateur de cohérence précédemment défini. Pendant les tranches $T_1$ et $T_5$, les estimations de fréquence sont jugées incohérentes et par conséquent l'information booléenne de cohérence prend la valeur '0'. Pendant les tranches $T_2$, $T_3$ et $T_4$, un signal utile est présent et les estimations fournies par l'IFM numérique sont jugées cohérentes. L'indicateur de cohérence prend alors la valeur '1'. '.

La troisième courbe 402 représente sous forme de croix les valeurs de fréquence estimées par le récepteur large bande prise en compte pour effectuer la détection d'enveloppe des impulsions selon l'invention. Durant les tranches $T_1$ et $T_5$, l'indicateur de cohérence est à '0', il n'y a pas de mesure de fréquence fournie. Au contraire, durant les tranches $T_2$, $T_3$ et $T_4$, l'indicateur de cohérence est à '1' et les valeurs des estimations de fréquence sont prises en compte pour la détection de l'enveloppe des impulsions. Durant les tranches $T_2$ et $T_4$, seul le signal correspondant à la première impulsion est reçu. Les mesures de fréquences seront donc associées à une piste de détection. Cette piste peut être définie par une valeur de fréquence $F_{courante}$ et un écart de fréquence $\Delta_{detec}$, une mesure de fréquence fine étant associée à ladite piste lorsque celle-ci appartient à la plage de fréquence $F_{courante}$ +/- $\Delta_{detec}$. Les estimations en fréquence sont, pour cette piste de détection, proches de la fréquence $F_1$ à une erreur d'estimation près. Durant la tranche $T_3$, les deux signaux correspondant aux deux impulsions sont présents, mais comme indiqué précédemment, la seconde impulsion est prépondérante. Les estimations en fréquence disponibles sont alors proches de $F_2$ à une erreur près. Ces mesures sont alors associées à une seconde piste de détection. Ce sont ces estimations en fréquence qui vont être utilisées afin d'estimer l'enveloppe de ces deux impulsions, par exemple à l'aide de la méthode décrite à l'aide de la figure 3. Le résultat obtenu est alors :

- pour la première impulsion, TOA = $t_2$ et LI = $t_5$ - $t_2$ = $T_2$ +$T_3$ + $T_4$. La fréquence estimée est égale à $F_1$ à une erreur d'estimation près ;
- pour la seconde impulsion, TOA = $t_3$ et $L_1$ = $t_4$ - $t_3$ = $T_3$. La fréquence estimée est égale à $F_2$ à une erreur d'estimation près.

Dans cet exemple, les résultats de la détection d'enveloppe se focalisent sur la fréquence, sur le paramètre TOA et sur la largeur d'impulsion LI pour chaque impulsion, mais le récepteur peut contenir également des moyens pour estimer les paramètres de modulation lorsque les impulsions détectés sont modulées.

**Revendications**

1. Récepteur numérique hyperfréquence à large bande comprenant au moins une antenne (200), un amplificateur (201), un dispositif IFM numérique (214) de mesure de la fréquence du ou des signaux reçus, le récepteur étant **caractérisé en ce qu'**un indicateur de cohérence (212) des mesures de fréquence est calculé en analysant les valeurs que prennent lesdites mesures obtenues sur deux transformées de Fourier consécutives et que la présence d'impulsions de signal à l'entrée du récepteur est détectée (213) lorsque ledit indicateur (212) signale la cohérence d'au moins une mesure de fréquence.

2. Récepteur selon la revendication 1 **caractérisé en ce que** l'enveloppe de la ou des impulsions reçues est estimée en utilisant au moins l'indicateur de cohérence (212) et les mesures de fréquence calculés par l'IFM (211).

3. Récepteur selon l'une quelconque des revendications 1 ou 2 **caractérisé en ce que** les signaux reçus sont des impulsions radar.

4. Récepteur selon l'une quelconque des revendications précédentes **caractérisé en ce que** l'indicateur de cohérence (212) est un indicateur binaire.

5. Récepteur selon l'une quelconque des revendications précédentes **caractérisé en ce qu'**il associe une impulsion de signal détectée à une piste de détection, une piste de détection étant définie par une valeur de fréquence $F_{courante}$ et un écart de fréquence $\Delta_{detec}$, une mesure de fréquence étant associée à ladite piste lorsque celle-ci appartient à la plage de fréquence $F_{courante}$ +/- $\Delta_{detec}$.

6. Récepteur selon la revendication 5 **caractérisé en ce que** des impulsions de signal distinctes se chevauchant temporellement sont détectées en maintenant simultanément ouvertes plusieurs pistes de détection.

7. Récepteur selon l'une quelconque des revendications 5 ou 6 **caractérisée en ce que** la date d'arrivée TOA d'une impulsion détecté correspond à la date d'ouverte de la piste de détection associée à ladite impulsion.

8. Récepteur selon l'une quelconque des revendications 5 à 7 **caractérisée en ce que** la largeur LI d'une impulsion détecté est déterminée par la différence entre la date de la dernière mesure affectée à cette piste et la date d'ouverture de la piste de détection associée à ladite impulsion.

9. Récepteur selon l'une quelconque des revendications 5 à 8 **caractérisée en ce que** la ou les pistes de détection ouvertes à un instant donné sont fermées lorsqu'un nombre prédéfini de mesures de fréquence sont successivement jugées incohérentes.

**Claims**

1. A wideband ultra-high frequency digital receiver comprising at least one antenna (200), one amplifier (201) and one digital IFM device (214) for measuring the frequency of the one or more received signals, said receiver being **characterised in that** an indicator (212) of the coherence of the frequency measurements is calculated by analysing the values that are assumed by said measurements obtained over two consecutive Fourier transforms and that the presence of signal pulses at the input of the receiver is detected (213) when said indicator (212) signals the coherence of at least one frequency measurement.

2. The receiver according to claim 1, **characterised in that** the envelope of the one or more received pulses is estimated using at least the coherence indicator (212) and the frequency measurements calculated by the IFM (211).

3. The receiver according to claim 1 or 2, **characterised in that** the received signals are radar pulses.

4. The receiver according to any one of the preceding claims, **characterised in that** the coherence indicator (212) is a binary indicator.

5. The receiver according to any one of the preceding claims, **characterised in that** it associates a detected signal pulse with a detection track, a detection track being defined by a frequency value $F_{courante}$ and a frequency shift $\Delta_{detec}$, a frequency measurement being associated with said track when said track belongs to the frequency range $F_{courante} +/\Delta_{detec}$.

6. The receiver according to claim 5, **characterised in that** temporally overlapping distinct signal pulses are detected by simultaneously keeping open a plurality of detection tracks.

7. The receiver according to claim 5 or 6, **characterised in that** the time of arrival TOA of a detected pulse corresponds to the time of opening of the detection track associated with said pulse.

8. The receiver according to any one of claims 5 to 7, **characterised in that** the width LI of a detected pulse is determined by the difference between the time of the last measurement assigned to this track and the time of opening of the detection track associated with said pulse.

9. The receiver according to any one of claims 5 to 8, **characterised in that** the one or more detection tracks that are open at a given instant are closed when a predefined number of frequency measurements is successively deemed to be incoherent.


**Patentansprüche**

1. Breitbandiger Hyperfrequenz-Digitalempfänger, der mindestens eine Antenne (200), einen Verstärker (201), eine digitale IFM-Messvorrichtung (214) der Frequenz des oder der empfangenen Signale umfasst, wobei der Empfänger **dadurch gekennzeichnet ist, dass** ein Kohärenzindikator (212) der Frequenzmessungen durch Analysieren der Werte, die die auf zwei aufeinanderfolgenden Fourier-Transformationen erhaltenen Messungen annehmen, berechnet wird und dass das Vohandensein von Signalimpulsen am Eingang des Empfängers erfasst wird (213), wenn der Indikator (212) die Kohärenz mindestens einer Frequenzmessung signalisiert.

2. Empfänger nach Anspruch 1, **dadurch gekennzeichnet, dass** die Hülle des oder der empfangenen Impulse durch Verwendung mindestens des Kohärenzindikators (212) und der von der IFM (211) berechneten Frequenzmessungen bewertet wird.

3. Empfänger nach einem der Ansprüche 1 oder 2, **dadurch gekennzeichnet, dass** die empfangenen Signale Radarimpulse sind.

4. Empfänger nach einem der vorangehenden Ansprüche, **dadurch gekennzeichnet, dass** der Kohärenzindikator (212) ein binärer Indikator ist.

5. Empfänger nach einem der vorangehenden Ansprüche, **dadurch gekennzeichnet, dass** er einem erfassten Signalimpuls einer Erfassungsbahn zuordnet, wobei eine Erfassungsbahn durch einen Frequenzwert $F_{courante}$ und eine Frequenzabweichung $\Delta_{detec}$ definiert ist, wobei eine Frequenzmessung der Bahn zugeordnet ist, wenn diese zum Frequenzbereich $F_{courante} +/- \Delta_{detec}$ gehört.

6. Empfänger nach Anspruch 5, **dadurch gekennzeichnet, dass** unterschiedliche Signalimpulse, die sich zeitweise überlappen, erfasst werden, indem mehrere Erfassungsbahnen gleichzeitig offengehalten werden.

7. Empfänger nach einem der Ansprüche 5 oder 6, **dadurch gekennzeichnet, dass** der Ankunftszeitpunkt TOA eines erfassten Impulses dem Öffnungszeitpunkt der dem Impuls zugeordneten Erfassungsbahn entspricht.

8. Empfänger nach einem der Ansprüche 5 bis 7, **dadurch gekennzeichnet, dass** die Breite LI eines erfassten Impulses durch die Differenz zwischen dem Zeitpunkt der letzten Messung, die dieser Bahn zugeteilt ist, und dem Zeitpunkt der Öffnung der Erfassungsbahn, der dem Impuls zugeordnet ist, bestimmt wird.

9. Empfänger nach einem der Ansprüche 5 bis 8, **dadurch gekennzeichnet, dass** die zu einem bestimmten Moment geöffneten Erfassungsbahn(en) geschlossen werden, wenn eine vorbestimmte Anzahl von Frequenzmessungen aufeinanderfolgend als inkohärent beurteilt werden.

FIG.1

FIG.2

FIG.3

EP 2 366 117 B1

FIG.4

**EP 2 366 117 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0601205
- US 7266465 B1